# EUROPEAN PATENT APPLICATION

(11) **EP 4 826 444 A1**
(43) Date of publication of application: **21.10.2026**
(21) Application number: 24903654.2
(22) Date of filing: 09.12.2024
(51) Int. Cl.: G03F 1/24, G03F 1/54

(54) **REFLECTIVE MASK BLANK, REFLECTIVE MASK, AND METHOD FOR MANUFACTURING REFLECTIVE MASK**

(30) Priority: 14.12.2023 JP 2023211554
(71) Applicant: Tekscend Photomask Corp., Tokyo 105-7133 (JP)
(72) Inventor: IWAI, Yuto, Tokyo 105-7133 (JP); NAKANO, Hideaki, Tokyo 105-7133 (JP); SAKURAI, Daisuke, Tokyo 105-7133 (JP); TAKEDA, Naoya, Tokyo 105-7133 (JP); MIYAWAKI, Daisuke, Tokyo 105-7133 (JP); SEKI, Kazunori, Tokyo 105-7133 (JP)
(74) Representative: TBK
(86) International application number: PCT/JP2024/043408
(87) International publication number: WO 2025/127000

(57) **Abstract**

An object of the present invention is to provide a reflective mask for patterning transfer using light having a wavelength in an extreme ultraviolet region as a light source, the reflective mask including an absorption film having resistance to hydrogen radicals, and to provide a reflective mask blank used for producing the reflective mask and a method for producing a reflective mask using the reflective mask blank. The reflective photomask blank (10) according to the present embodiment includes: a substrate (1); a reflective layer (2) formed on the substrate (1) and configured to reflect EUV light; and an absorption layer (4) formed on the reflective layer (2) and configured to absorb EUV light, in which the absorption layer (4) contains platinum (Pt) in a largest amount among all elements constituting the absorption layer (4) and contains at least one element selected from a first material group other than the platinum (Pt), and the absorption layer (4) has a film density of 9.0 g/cm³ or more.

## Description

### TECHNICAL FIELD

The present invention relates to a reflective mask blank, a reflective mask, and a method for producing a reflective mask.

### BACKGROUND ART

In a production process of a semiconductor device, a demand for miniaturization by photolithography technology has been increasing with miniaturization of the semiconductor device. In photolithography, a minimum resolution dimension of a transfer pattern greatly depends on a wavelength of an exposure light source, and a shorter wavelength enables a smaller minimum resolution dimension. Therefore, in the exposure light source, ArF excimer laser light having a wavelength of 193 nm in the related art has been undergoing replacement with light in an extreme ultraviolet (EUV) region having a wavelength of 13.5 nm.

Since the light in the EUV region is absorbed at a high rate by most materials, a reflective photomask is used as a photomask for EUV exposure (EUV mask) (see, for example, Patent Literature 1). Patent Literature 1 discloses an EUV photomask obtained by forming a reflective layer made of a multilayer film where a molybdenum (Mo) layer and a silicon (Si) layer are alternately deposited on a glass substrate, forming a light absorption layer containing tantalum (Ta) as a main component thereon, and forming a pattern on this light absorption layer.

In EUV lithography, as described above, a refractive optical system using light transmission cannot be used, and thus an optical system member of an exposure apparatus is also not a lens but a reflective type member (mirror). This causes a problem that incident light on a reflective photomask (EUV mask) and reflected light from the EUV mask cannot be designed coaxially. EUV lithography basically employs a technique of allowing EUV light to be incident with an optical axis tilted by 6 degrees from a direction perpendicular to the EUV mask, and guiding reflected light reflected at an angle of -6 degrees to a semiconductor substrate.

In this way, in the EUV lithography, the optical axis is tilted through the mirror, and this may cause a problem called a "shadowing effect" in which the EUV light incident on the EUV mask forms a shadow of a mask pattern (patterned light absorption layer) of the EUV mask.

In a current EUV mask blank, a film having a film thickness of 60 nm to 90 nm and containing tantalum (Ta) as a main component is used as a light absorption layer. When pattern transfer exposure is performed using an EUV mask produced using this mask blank, a contrast might be reduced at an edge portion that is a shadow of a mask pattern depending on a relationship between incident direction of an EUV light and an orientation of the mask pattern. In addition, problems may occur, such as an increase in line edge roughness of a transfer pattern on a semiconductor substrate and an inability to form a line width at a target dimension, and these may lead to deterioration in transfer performance.

Therefore, a reflective photomask blank has been studied in which a light absorption layer is changed from tantalum (Ta) to a material having high absorptivity (extinction coefficient) with respect to EUV light, or the material having high absorptivity is added to tantalum (Ta). For example, Patent Literature 1 discloses a reflective photomask blank in which a light absorption layer is made of a material containing 50 atomic% (at%) or more of Ta as a main component and further containing at least one element selected from Te, Sb, Pt, I, Bi, Ir, Os, W, Re, Sn, In, Po, Fe, Au, Hg, Ga, and Al.

Further, it is known that a mirror is contaminated by carbon and a by-product (for example, Sn) caused by EUV irradiation, and the like. Accumulation of contaminants on the mirror reduces reflectivity of a mirror surface and reduces throughput of a lithography apparatus. To solve this problem, Patent Literature 2 discloses a method for removing contaminants from a mirror by generating hydrogen radicals in an apparatus and allowing the hydrogen radicals to react with the contaminants. As described above, a material used for a reflective photomask blank and a reflective photomask is required to have high resistance to hydrogen radicals.

However, among materials having high absorptivity to EUV light, some materials have low hydrogen radical resistance, and a reflective mask formed of a material having low hydrogen radical resistance has a problem in that the reflective mask cannot withstand long-term use.

### CITATION LIST

### PATENT LITERATURE

| | |
|---|---|
| Patent Literature 1: | JP4926523B |
| Patent Literature 2: | JP2011-530823A |

### SUMMARY OF INVENTION

### TECHNICAL PROBLEM

The present disclosure has been made under the circumstances described above, and an object thereof is to provide a reflective mask for patterning transfer using light having a wavelength in an extreme ultraviolet region as a light source, the reflective mask including an absorption film having resistance to hydrogen radicals, and to provide a reflective mask blank used for producing the reflective mask and a method for producing a reflective mask using the reflective mask blank.

### SOLUTION TO PROBLEM

The present disclosure has been made to solve the problems described above, and a reflective mask blank according to one aspect of the present disclosure includes: a substrate; a reflective layer formed on the substrate and configured to reflect EUV light; and an absorption layer formed on the reflective layer and configured to absorb EUV light, in which the absorption layer contains platinum (Pt) in a largest amount among all elements constituting the absorption layer and contains at least one element selected from a first material group other than the platinum (Pt), and the absorption layer has a film density of 9.0 g/cm³ or more.

A reflective mask according to one aspect of the disclosure includes: a substrate; a reflective layer formed on the substrate and configured to reflect EUV light; and a patterned absorption layer formed on the reflective layer and configured to absorb EUV light, in which the absorption layer contains platinum (Pt) in a largest amount among elements constituting the absorption layer and contains at least one element selected from a first material group other than the platinum (Pt), and the absorption layer has a film density of 9.0 g/cm³ or more.

A method for producing a reflective mask according to one aspect of the present disclosure includes: forming, on a substrate, a reflective layer that reflects EUV light; and forming, on the reflective layer, an absorption layer that absorbs EUV light and is patterned, in which the absorption layer contains platinum (Pt) in a largest amount among elements constituting the absorption layer and contains at least one element selected from a first material group other than the platinum (Pt), and the absorption layer has a film density of 9.0 g/cm³ or more.

### ADVANTAGEOUS EFFECTS OF INVENTION

According to the reflective mask blank according to one aspect of the present disclosure, sufficient hydrogen radical resistance is obtained, and an absorption layer can be formed. That is, the reflective mask blank according to one aspect of the present disclosure can provide a reflective mask blank having high hydrogen radical resistance.

In addition, the reflective mask according to one aspect of the present disclosure can provide a reflective mask having high hydrogen radical resistance.

In addition, the method for producing a reflective mask according to one aspect of the present disclosure can provide a reflective mask having high hydrogen radical resistance.

In this way, one aspect of the present disclosure allows for providing a reflective mask for patterning transfer using light having a wavelength in an extreme ultraviolet region as a light source, the reflective mask including an absorption film having resistance to hydrogen radicals, and for providing a reflective mask blank used for producing the reflective mask and a method for producing a reflective mask using the reflective mask blank.

### BRIEF DESCRIPTION OF DRAWINGS

FIG. 1 is a cross-sectional view schematically illustrating a configuration of a reflective photomask blank according to an embodiment of the present invention.
FIG. 2 is a cross-sectional view schematically illustrating a configuration of a reflective photomask according to the embodiment of the present invention.
FIG. 3 is a graph indicating optical constants of metals at an EUV light wavelength.

### DESCRIPTION OF EMBODIMENTS

As a result of intensive studies, the present inventors have found that an absorption layer has excellent hydrogen radical resistance when the absorption layer contains platinum (Pt) in a largest amount among all elements constituting the absorption layer, contains an element other than platinum (Pt) (at least one element selected from a first material group), and further, a film density of the absorption layer is 9.0 g/cm³ or more.

That is, the present disclosure proposes and provides a new design concept for improving the hydrogen radical resistance of the absorption layer. This point will be described below.

In a design concept in the related art, in order to improve the hydrogen radical resistance of the absorption layer, elements constituting the absorption layer have been focused on, and types, content, composition ratios, and the like thereof have been adjusted.

In contrast, the present inventors have found that excellent hydrogen radical resistance can be imparted to the absorption layer by specifying platinum (Pt) as a main element (element having a largest content) constituting the absorption layer and setting the film density of the absorption layer to a specific value. That is, it has been newly found that not only the constituent elements of the absorption layer but also the film density of the absorption layer are important for imparting excellent hydrogen radical resistance to the absorption layer.

In this way, the design concept in the present disclosure is significantly different from the design concept in the related art, which has focused on only the constituent elements and the like of the absorption layer.

An embodiment of the present invention will be described with reference to the drawings.

Here, a structure illustrated in the drawings is schematic, and a relationship between a thickness and a planar dimension, a ratio of a thickness of each layer, and the like are different from actual ones. In addition, the embodiments described below show a configuration for embodying the technical concept of the present invention as an example, and the technical concept of the present invention is not limited to materials, shapes, structures, and the like of the components described below. Various modifications can be made to the technical concept of the present invention within the technical scope defined by the claims.

### (Configurations of Reflective Photomask Blank and Reflective Photomask)

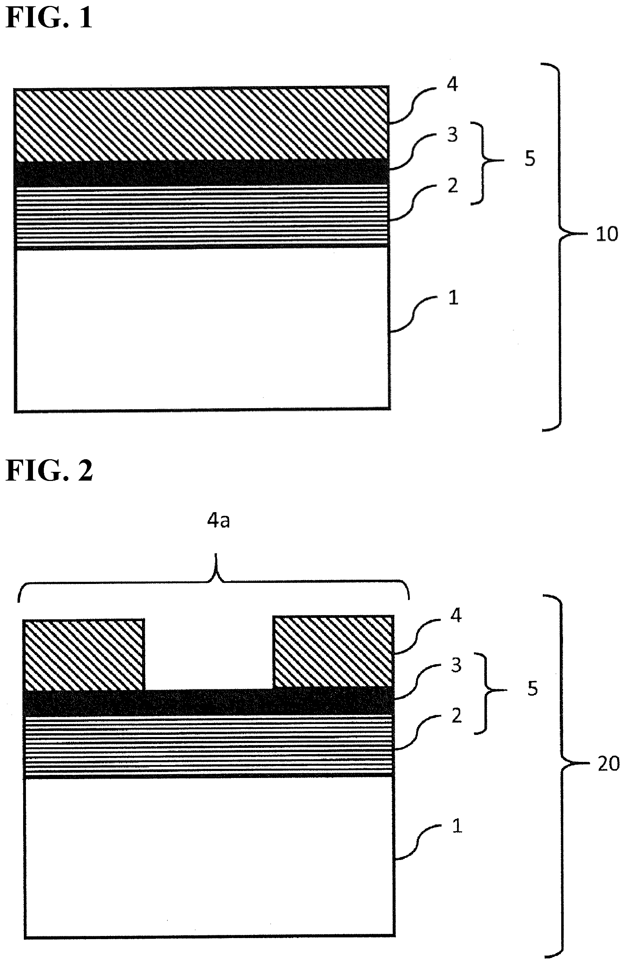

FIG. 1 is a schematic cross-sectional view illustrating a structure of a reflective photomask blank (reflective mask blank) 10 according to an embodiment of the present invention. As illustrated in FIG. 1, the reflective photomask blank 10 according to the embodiment of the present invention includes a substrate 1, a reflective layer 2 formed on the substrate 1 and having, for example, a multilayer film structure to reflect EUV light, a protective layer (capping layer) 3 formed on the reflective layer 2, and an absorption layer 4 formed on the protective layer 3 to absorb EUV light. The reflective layer 2 and the protective layer (capping layer) 3 constitute a reflective portion 5.

A reflective photomask (reflective mask) 20 according to the embodiment of the present invention is produced by forming a transfer pattern on the reflective layer 2 of the reflective photomask blank 10 according to the embodiment of the present invention.

Hereinafter, each layer constituting the reflective photomask blank 10 according to the embodiment of the present invention will be described in detail.

### (Substrate)

As the substrate 1 according to the embodiment of the present invention, for example, a flat Si substrate or a synthetic quartz substrate can be used. In the substrate 1, low thermal expansion glass to which titanium is added can be used, and the present invention is not limited thereto as long as a material having a low coefficient of thermal expansion is used.

Although not shown, a backside conductive film can be formed on a surface of the substrate 1 on which the reflective layer 2 is not formed. The backside conductive film is a film for fixing the reflective photomask produced using the reflective photomask blank 10 according to the embodiment of the present invention, using a principle of an electrostatic chuck when the reflective photomask is set in an exposure apparatus.

### (Reflective Layer)

The reflective layer 2 according to the embodiment of the present invention may be any reflective layer that reflects extreme ultraviolet light (EUV light), which is exposure light, and may be a multilayer reflective film (that is, an EUV light reflective film having a multilayer film structure) formed by combining materials having significantly different refractive indices with respect to EUV light. For example, the reflective layer 2 containing the multilayer reflective film may be formed by repeatedly depositing layer pairs such as molybdenum (Mo) and silicon (Si), or molybdenum (Mo) and beryllium (Be), for about 40 periods.

### (Protective Layer)

The protective layer 3 according to the embodiment of the present invention is a layer that functions as an etching stopper for preventing damage to the reflective layer 2 when the absorption layer 4 is etched at the time of forming the photomask. The protective layer 3 may not be formed depending on the material of the reflective layer 2 and etching conditions. The protective layer 3 is formed of a material having resistance to dry etching performed during pattern formation of the absorption layer 4. For example, the material of the protective layer 3 may be ruthenium (Ru).

### (Absorption Layer)

As illustrated in FIG. 1, the absorption layer 4 is a layer formed on the protective layer 3 and absorbs EUV light that is exposure light.

Since the reflective photomask 20 in FIG. 2 is exposed to a hydrogen radical environment, the reflective photomask 20 cannot withstand long-term use unless the absorption layer 4 is formed of a light absorbing material having high hydrogen radical resistance. In the present embodiment, a material having a film loss rate of 0.1 nm/s or less in a hydrogen radical environment with power of 1 kW and hydrogen pressure of 0.36 millibar (mbar) or less using microwave plasma is defined as the material having high hydrogen radical resistance.

By using platinum (Pt) as a main material constituting the absorption layer 4, that is, by making platinum (Pt) have highest content (atomic%) among all elements constituting the absorption layer 4, the resistance can be significantly increased, and a criterion of the hydrogen radical resistance described above can be satisfied. It is conceivable that this is because strength is improved by mixing platinum (Pt) having resistance to hydrogen radicals, which contributes to improvement in stability as a compound.

Regarding the criterion of hydrogen radical resistance, in a film loss rate evaluation test shown in Table 1, a measurement of the film loss rate was repeated a plurality of times, and a case where the film loss rate was 0.1 nm/s or less in all measurements was evaluated as "⊚", a case where there was a variation in the film loss rate but the film loss rate was 0.1 nm/s or less in half or more of the measurements was evaluated as "○", and a case where the film loss rate was more than 0.1 nm/s in all the measurements was evaluated as "×". In the present embodiment, there is no problem in use when the evaluation is "○", and the evaluation of "⊚" is more preferable in use.

The absorption layer 4 in the present embodiment is formed of a material containing platinum (Pt) as a main material, and a film density of the absorption layer 4 is 9.0 g/cm³ or more. That is, the absorption layer 4 in the present embodiment contains platinum (Pt) in a largest amount among all elements (atomic%) constituting the absorption layer 4, and the film density of the absorption layer 4 is 9.0 g/cm³ or more. When the film density of the absorption layer 4 is less than 9.0 g/cm³, bonding is unstable and microscopic voids are also present inside the film, and thus the hydrogen radical resistance may not be sufficiently achieved. In addition, absorption performance with respect to EUV light may not be sufficiently obtained. Meanwhile, an upper limit of the film density of the absorption layer 4 is not limited, but as the film density increases, processability by dry etching tends to be difficult. In particular, when the film density exceeds 22.0 g/cm³, the processability by dry etching tends to be difficult. Therefore, in order to obtain excellent hydrogen radical resistance and excellent dry etching processability, the film density of the absorption layer 4 is preferably 9.0 g/cm³ or more, more preferably in a range of 10.0 g/cm³ or more and 22.0 g/cm³ or less, and still more preferably in a range of 11.0 g/cm³ or more and 20.0 g/cm³ or less.

In the present embodiment, the film density of the absorption layer 4 can be adjusted to a target value by adjusting a composition ratio between platinum (Pt) and at least one element selected from the first material group to be described later.

The film density of the absorption layer 4 may be calculated based on a measurement result of Rutherford backscattering spectrometry (RBS), for example.

Measurement conditions for calculating the film density using Rutherford backscattering spectrometry (RBS) are shown below.
Incident ions: 2.275 MeV 4He++
Beam diameter: 1 mmφ to 2 mmφ
RBS detection angle: Normal Angle 160 degrees
: Grazing Angle to 108 degrees

An outermost surface of the absorption layer 4 may be oxidized through natural oxidation by a reaction with oxygen in the atmosphere or a blank preparation step such as cleaning processing. In addition, a graded configuration in which a component of the absorption layer 4 changes stepwise from a surface layer toward the side of the substrate 1 may be adopted. That is, a graded configuration in which a concentration of the constituent component of the absorption layer 4 changes stepwise from the outermost surface side toward the side of the substrate 1 may be adopted.

The material constituting the absorption layer 4 contains platinum (Pt) and one or more elements selected from the first material group to be described later. That is, the absorption layer 4 contains platinum (Pt) as a main material and contains one or more elements selected from the first material group. Here, the term "main material" means an element (material) contained in an amount of 51 atomic% or more among all metal elements constituting the absorption layer 4. In other words, 51 atomic% or more of all the metal elements constituting the absorption layer 4 is platinum (Pt), and content of the one or more elements selected from the first material group is 49 atomic% or less. That is, a lower limit of the content of platinum (Pt) contained in the absorption layer 4 is 51 atomic% with respect to all the metal elements constituting the absorption layer 4, and an upper limit of the content of the one or more elements selected from the first material group is 49 atomic% with respect to all the metal elements constituting the absorption layer 4. When the content of each of platinum (Pt) and the one or more elements selected from the first material group is within the numerical ranges described above, hydrogen radical resistance can be provided, and an influence of a shadowing effect (shadowing) can be minimized.

The upper limit of the content of platinum (Pt) contained in the absorption layer 4 is not limited, but may be 99 atomic% with respect to all the metal elements constituting the absorption layer 4.

The lower limit of the content of the one or more elements selected from the first material group is not limited, but may be 1 atomic% with respect to all the metal elements constituting the absorption layer 4.

In the present embodiment, the first material group preferably includes at least one element selected from niobium (Nb), ruthenium (Ru), iridium (Ir), tantalum (Ta), titanium (Ti), chromium (Cr), indium (In), nickel (Ni), cobalt (Co), bismuth (Bi), iron (Fe), gold (Au), palladium (Pd), rhenium (Re), tin (Sn), oxygen (O), nitrogen (N), and boron (B), and more preferably includes at least one element selected from niobium (Nb), ruthenium (Ru), iridium (Ir), tantalum (Ta), titanium (Ti), chromium (Cr), indium (In), oxygen (O), nitrogen (N), and boron (B).

In the present embodiment, the first material group may contain carbon (C).

When the first material group includes at least one element selected from niobium (Nb), ruthenium (Ru), iridium (Ir), tantalum (Ta), titanium (Ti), chromium (Cr), indium (In), nickel (Ni), cobalt (Co), bismuth (Bi), iron (Fe), gold (Au), palladium (Pd), rhenium (Re), tin (Sn), oxygen (O), nitrogen (N), and boron (B), hydrogen radical resistance and smoothness of the absorption layer 4 are appropriately balanced as compared to a case where another element is used, thereby providing excellent film properties.

When the first material group includes at least one element selected from niobium (Nb), ruthenium (Ru), iridium (Ir), tantalum (Ta), titanium (Ti), chromium (Cr), indium (In), oxygen (O), nitrogen (N), and boron (B), the hydrogen radical resistance and the smoothness of the absorption layer 4 are appropriately balanced as compared to a case where another element is used, thereby providing more excellent film properties.

In addition, among the elements belonging to the first material group, content of non-metal elements is preferably in a range of 0 atomic% or more and 25 atomic% or less of all the elements constituting the absorption layer 4, more preferably in a range of 0 atomic% or more and 20 atomic% or less of all the elements constituting the absorption layer 4, and still more preferably in a range of 0 atomic% or more and 15 atomic% or less of all the elements constituting the absorption layer 4.

The film density is usually determined by a ratio of alloy species, and the present inventors have found that a density of the absorption layer 4 is increased by introducing a light element (for example, O, N, B, or C) that can acquire high binding energy into the absorption layer 4.

In addition, the present inventors have found that the density of the absorption layer 4 can be easily adjusted by adjusting an introduction amount (addition amount) of the light element into the absorption layer 4.

For example, when the introduction amount of the light element described above is 0.001 atomic% to 1.0 atomic% of all the elements constituting the absorption layer 4, the film density of the absorption layer 4 increases in a range of 1% to 3%.

Specifically, when 5 atomic% or more of the light element is introduced into the absorption layer 4, the density of the absorption layer 4 tends to decrease, and when the introduction amount of the light element in the absorption layer 4 is an extremely small amount such as 0.001 atomic% to 1.0 atomic%, the density of the absorption layer 4 tends to increase. That is, a strict proportional relationship is not established between the composition (specifically, the introduction amount of the light element) of the absorption layer 4 and the density of the absorption layer 4.

The film density of the absorption layer 4 may be calculated, for example, based on a measurement result of X-ray reflectivity (XRR).

Measurement conditions for calculating the film density using X-ray reflectivity (XRR) are shown below.
Incident X-rays: Cu Kα radiation (wavelength: 1.54 Å)
X-ray reflection angle: range of 0.2 degrees to 5 degrees
Measurement scan speed: 0.02 degrees/sec
Detector: scintillation counter
Data analysis: fitting is performed on a reflectivity profile to calculate a film thickness, roughness, and the film density.

By this measurement, the density of the film can be evaluated with high accuracy.

The film density and an elemental distribution of the absorption layer 4 may be calculated based on, for example, a measurement result of secondary ion mass spectrometry (SIMS).

Measurement conditions for measuring the film density or the elemental distribution using secondary ion mass spectrometry (SIMS) are shown below.
Incident ions: Cs⁺ ions (energy: 5.0 keV) or O₂⁺ ions (energy: 10.0 keV)
Beam diameter: 50 nm to 200 nm
Sputtering rate: 0.1 nm/s to 1.0 nm/s
Mass spectrometer: quadrupole mass spectrometer or time-of-flight mass spectrometer (TOF-SIMS)
Detected mass range: 1 amu to 300 amu
Measurement target: a depth-direction elemental concentration profile and the film density are estimated.

As described above, for example, by introducing the light element such as oxygen (O), nitrogen (N), boron (B), or carbon (C) into the absorption layer 4, the absorption layer 4 can be easily densified with high accuracy.

In addition, the density of the absorption layer 4 can be easily adjusted with high accuracy by adjusting the introduction amount of the light element within a range of 0.001 atomic% to 1.0 atomic% with respect to all the elements constituting the absorption layer 4.

When the density of the absorption layer 4 is adjusted to 9.0 g/cm³ or more by adjusting the introduction amount of the light element in the range of 0.001 atomic% to 1.0 atomic% with respect to all the elements constituting the absorption layer 4, excellent hydrogen radical resistance and excellent smoothness can be imparted to the absorption layer 4.

The absorption layer 4 preferably contains 51 atomic% or more of platinum (Pt), more preferably 60 atomic% or more, and still more preferably 70 atomic% or more among the metal elements other than the non-metal elements among the elements constituting the absorption layer 4.

When the absorption layer 4 contains 51 atomic% or more of platinum (Pt) among the metal elements other than the non-metal elements among the elements constituting the absorption layer 4, the influence due to the shadowing effect can be reduced as compared to a case where another element is used.

When the absorption layer 4 contains 60 atomic% or more of platinum (Pt) among the metal elements other than the non-metal elements among the elements constituting the absorption layer 4, the influence due to the shadowing effect can be more reduced as compared to a case where another element is used.

When the absorption layer 4 contains 70 atomic% or more of platinum (Pt) among the metal elements other than the non-metal elements among the elements constituting the absorption layer 4, the influence due to the shadowing effect can be further reduced as compared to a case where another element is used.

The composition ratio of the materials constituting the absorption layer 4 is calculated based on an analysis result by Rutherford backscattering spectrometry (RBS), and the content may vary depending on an analysis method. For example, as a result of analyzing, using X-ray photoelectron spectroscopy (XPS), a material in which the content of platinum (Pt) is 51 atomic% to 99 atomic% among all metal elements in RBS analysis, the content may be 40 atomic% to 75 atomic% among all metal elements. As a result of analyzing, using energy dispersive X-ray spectroscopy (EDX), the material in which the content of platinum (Pt) is 51 atomic% to 99 atomic% among all metal elements in RBS analysis, the content may be 45 atomic% to 100 atomic% among all metal elements.

The absorption layer 4 preferably has a film thickness of less than 60 nm in order to obtain transferability equal to or higher than that of an EUV mask according to the related art that includes a light absorption film having a film thickness of 60 nm to 90 nm and containing Ta as a main component.

The absorption layer 4 more preferably has a film thickness of 55 nm or less in order to obtain the transferability equal to or higher than that of the EUV mask according to the related art including the light absorption film having the film thickness of 60 nm to 90 nm and containing Ta as the main component.

The absorption layer 4 more preferably has a film thickness of 45 nm or less in order to obtain the transferability equal to or higher than that of the EUV mask according to the related art including the light absorption film having the film thickness of 60 nm to 90 nm and containing Ta as the main component.

As long as the film thickness of the absorption layer 4 is less than 60 nm, the shadowing effect (shadowing) is reduced, and excellent transferability can be achieved as compared to the existing film.

The configuration described above allows for providing the reflective photomask blank 10 and the reflective photomask 20 for patterning transfer using light having a wavelength in the extreme ultraviolet region as a light source, each of which includes an absorption film having resistance to hydrogen radicals.

In FIG. 2, an optical density (OD) value, which is an index indicating a light intensity contrast between the reflective portion 5 and the absorption layer 4, is defined by the following (formula 1), where Rm is defined as an intensity of reflected light from the reflective portion 5, and Ra is defined as an intensity of reflected light from the absorption layer 4. $OD = - log \left(Ra/Rm\right)$ formula (1)

As the OD value increases, the contrast becomes more favorable and the high transferability is achieved. In pattern transfer, OD > 1 is preferable, and 1.5 or more is further preferable.

In the present embodiment, the OD value of the absorption layer 4 is preferably 1.0 or more, and further preferably 1.5 or more.

As long as the OD value of the absorption layer 4 is 1.0 or more, a sufficient contrast can be achieved, and transfer performance required for use can be achieved.

The material constituting the absorption layer 4 may contain a material (element) other than platinum (Pt) and the elements in the first material group.

When the material constituting the absorption layer 4 contains, for example, beryllium (Be), calcium (Ca), scandium (Sc), vanadium (V), manganese (Mn), copper (Cu), germanium (Ge), arsenic (As), strontium (Sr), technetium (Tc), rhodium (Rh), barium (Ba), rhenium (Re), osmium (Os), boron (B), nitrogen (N), and/or oxygen (O), the material can be made sufficiently amorphous. Forming the absorption layer 4 with the amorphous material allows for improving roughness, in-plane dimensional uniformity, and in-plane uniformity of a transferred image.

Including, for example, zirconium (Zr), hafnium (Hf), yttrium (Y), lead (Pb), and/or gallium (Ga) in the material constituting the absorption layer 4 makes the material to be less likely to react with hydrogen radicals, thereby increasing its hydrogen radical resistance.

Including, for example, chromium (Cr) and/or aluminum (Al) in the material constituting the absorption layer 4 allows for forming an oxide film having hydrogen radical resistance to cover an exposed surface of the absorption layer 4 when the absorption layer 4 is patterned to produce the photomask.

Including, for example, silicon nitride (SiN) and/or tantalum oxide (TaO) in the material constituting the absorption layer 4 allows the material to have high light absorption at a wavelength of 190 nm to 260 nm, thereby improving contrast of inspection light.

Including, for example, cobalt (Co), palladium (Pd), molybdenum (Mo), and/or silver (Ag) in the material constituting the absorption layer 4 allows the material to have a refractive index n of less than 0.95 at a wavelength of 13.5 nm, thereby improving phase shifting properties.

Including, for example, tellurium (Te), tin (Sn), and/or nickel (Ni) in the material constituting the absorption layer 4 allows the material to have a high extinction coefficient, thereby reducing the shadowing effect.

Although an example of effects of materials that can be contained in the absorption layer 4 has been described above, an effect of each material is not limited to the above example, and each material may correspond to a plurality of effects.

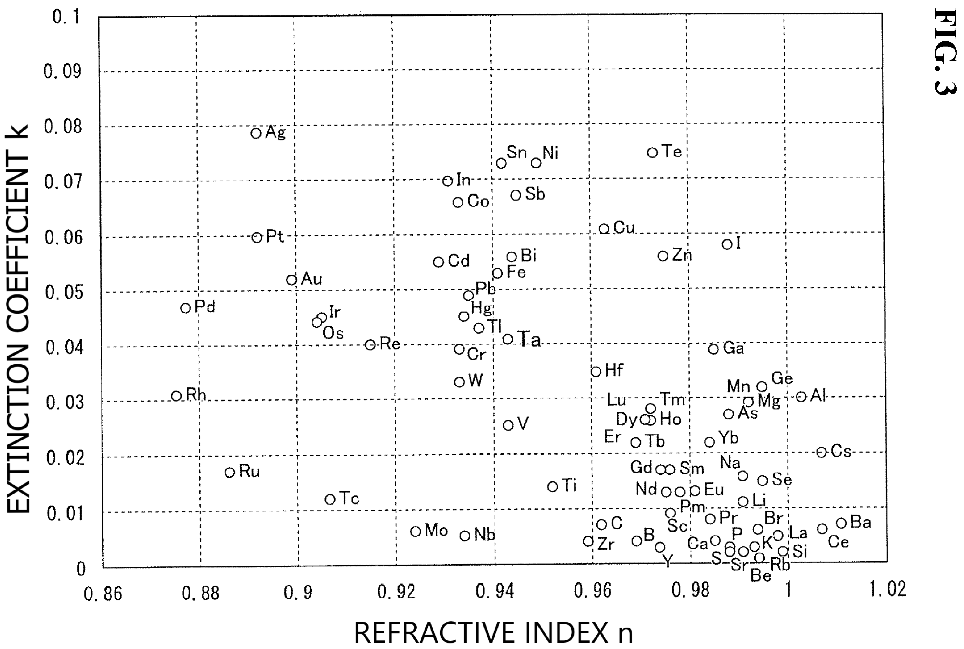

As illustrated in FIG. 3, when the composition ratio of platinum (Pt) having a relatively large extinction coefficient k is increased in the absorption layer 4, that is, when the content of platinum (Pt) is increased, the shadowing effect can be reduced. In addition, a high phase shifting effect can be achieved by appropriately adjusting the composition ratio of platinum (Pt) in the absorption layer 4 and increasing the refractive index n.

### (Method for Producing Reflective Photomask)

A method for producing the reflective photomask 20 according to the embodiment of the present disclosure includes forming the reflective layer 2 that reflects EUV light on the substrate 1, and forming the patterned absorption layer 4 that absorbs EUV light on the reflective layer 2, in which the absorption layer 4 contains platinum (Pt) in a largest amount among elements constituting the absorption layer 4 and contains at least one element selected from the first material group other than platinum (Pt), and the absorption layer 4 has a film density of 9.0 g/cm³ or more.

That is, the method for producing the reflective photomask 20 according to the embodiment of the present disclosure includes forming the reflective layer 2 that reflects EUV light on the substrate 1, and forming the patterned absorption layer 4 that absorbs EUV light on the reflective layer 2. In the step of forming the absorption layer 4, the absorption layer 4 is formed of platinum (Pt) and at least one element selected from the first material group such that the content (atomic%) of platinum (Pt) is largest among the elements constituting the absorption layer 4 and further the film density of the absorption layer 4 is 9.0 g/cm³ or more.

The above production method allows for providing the reflective photomask 20 for patterning transfer using light having a wavelength in the extreme ultraviolet region as a light source and including the absorption film having resistance to hydrogen radicals.

As described above, when the reflective photomask blank 10 includes at least the substrate 1, the reflective layer 2 that is formed on the substrate 1, includes, for example, a multilayer film structure, and is configured to reflect EUV light, and the absorption layer 4 formed on the reflective layer 2 and configured to absorb EUV light, the absorption layer 4 contains platinum (Pt) as a main material and one or more elements selected from the first material group, and further the film density of the absorption layer 4 is 9.0 g/cm³ or more, smoothness and hydrogen radical resistance of the absorption layer 4 are improved.

### [Examples]

Hereinafter, the present disclosure will be described in more detail with reference to examples, but the present disclosure is not limited by these examples in any way.

### <Example 1>

A synthetic quartz substrate having low thermal expansivity was used as a substrate. On the substrate, a multilayer reflective film (reflective layer) was formed by stacking 40 stacks, each stack including a pair of silicon (Si) and molybdenum (Mo). A film thickness of the multilayer reflective film was set to 280 nm.

Next, a capping layer (protective layer) was deposited on the multilayer reflective film using ruthenium (Ru) such that a film thickness thereof was 3.5 nm. Accordingly, a reflective portion including the multilayer reflective film and the capping layer was formed on the substrate.

An absorption layer made of platinum (Pt) and titanium (Ti) was deposited on the capping layer.

Next, on a side of the substrate where the multilayer reflective film was not formed, a backside conductive film was deposited using chromium nitride (CrN) such that a thickness thereof was 100 nm.

Thus, a reflective photomask blank of Example 1 was prepared.

A multi-target sputtering apparatus was used for the deposition of the films on the substrate.

A composition of metal elements in the absorption layer of Example 1 formed as described above was measured by Rutherford backscattering spectrometry (RBS), and it was found that Pt was 51 atomic% and Ti was 49 atomic%.

Next, a resist film was formed by depositing a positive chemically amplified resist (SEBP9012: manufactured by Shin-Etsu Chemical Co., Ltd.) on the absorption layer to be a film thickness of 120 nm by spin coating, followed by baking at 110°C for 10 minutes.

Next, a predetermined pattern was drawn on the positive chemically amplified resist by an electron beam lithography apparatus (JBX3030: manufactured by JEOL Ltd.).

Thereafter, the resist was subjected to a baking treatment at 110°C for 10 minutes, and then subjected to spray development (SFG3000: manufactured by Sigmameltec Ltd.). Accordingly, a resist pattern was formed.

Next, using the resist pattern as an etching mask, the absorption layer was patterned by dry etching mainly using a chlorine-based gas to form an absorption layer pattern.

Next, the remaining resist pattern was peeled off. Thus, an absorption layer pattern where a surface and a sidewall of the absorption layer were exposed was formed.

In the present example, the absorption layer pattern was a line-and-space (LS) pattern having a line width of 64 nm.

Thus, a reflective photomask according to Example 1 was prepared.

### <Example 2>

An absorption layer made of platinum (Pt) and titanium (Ti) was deposited on the capping layer.

A reflective photomask blank and a reflective photomask of Example 2 were prepared in the same manner as in Example 1 except for the absorption layer.

A composition of metal elements in the absorption layer of Example 2 thus formed was measured by Rutherford backscattering spectrometry (RBS), and it was found that Pt was 60 atomic% and Ti was 40 atomic%.

### <Example 3>

An absorption layer made of platinum (Pt) and titanium (Ti) was deposited on the capping layer.

A reflective photomask blank and a reflective photomask of Example 3 were prepared in the same manner as in Example 1 except for the absorption layer.

A composition of metal elements in the absorption layer of Example 3 thus formed was measured by Rutherford backscattering spectrometry (RBS), and it was found that Pt was 70 atomic% and Ti was 30 atomic%.

### <Example 4>

An absorption layer made of platinum (Pt) and titanium (Ti) was deposited on the capping layer.

A reflective photomask blank and a reflective photomask of Example 4 were prepared in the same manner as in Example 1 except for the absorption layer.

A composition of metal elements in the absorption layer of Example 4 thus formed was measured by Rutherford backscattering spectrometry (RBS), and it was found that Pt was 99 atomic% and Ti was 1 atomic%.

### <Example 5>

An absorption layer made of platinum (Pt) and titanium oxide (Ti₂O) was deposited on the capping layer.

A reflective photomask blank and a reflective photomask of Example 5 were prepared in the same manner as in Example 1 except for the absorption layer.

A composition of metal elements in the absorption layer of Example 5 thus formed was measured by Rutherford backscattering spectrometry (RBS), and it was found that Pt was 51 atomic% and Ti₂O (total of Ti and O) was 49 atomic%.

### <Example 6>

An absorption layer made of platinum (Pt) and niobium (Nb) was deposited on the capping layer.

A reflective photomask blank and a reflective photomask of Example 6 were prepared in the same manner as in Example 1 except for the absorption layer.

A composition of metal elements in the absorption layer of Example 6 thus formed was measured by Rutherford backscattering spectrometry (RBS), and it was found that Pt was 51 atomic% and Nb was 49 atomic%.

### <Example 7>

An absorption layer made of platinum (Pt) and chromium (Cr) was deposited on the capping layer.

A reflective photomask blank and a reflective photomask of Example 7 were prepared in the same manner as in Example 1 except for the absorption layer.

A composition of metal elements in the absorption layer of Example 7 thus formed was measured by Rutherford backscattering spectrometry (RBS), and it was found that Pt was 51 atomic% and Cr was 49 atomic%.

### <Example 8>

An absorption layer made of platinum (Pt) and ruthenium (Ru) was deposited on the capping layer.

A reflective photomask blank and a reflective photomask of Example 8 were prepared in the same manner as in Example 1 except for the absorption layer.

A composition of metal elements in the absorption layer of Example 8 thus formed was measured by Rutherford backscattering spectrometry (RBS), and it was found that Pt was 51 atomic% and Ru was 49 atomic%.

### <Example 9>

An absorption layer made of platinum (Pt) and nickel (Ni) was deposited on the capping layer.

A reflective photomask blank and a reflective photomask of Example 9 were prepared in the same manner as in Example 1 except for the absorption layer.

A composition of metal elements in the absorption layer of Example 9 thus formed was measured by Rutherford backscattering spectrometry (RBS), and it was found that Pt was 51 atomic% and Ni was 49 atomic%.

### <Example 10>

An absorption layer made of platinum (Pt) and cobalt (Co) was deposited on the capping layer.

A reflective photomask blank and a reflective photomask of Example 10 were prepared in the same manner as in Example 1 except for the absorption layer.

A composition of metal elements in the absorption layer of Example 10 thus formed was measured by Rutherford backscattering spectrometry (RBS), and it was found that Pt was 51 atomic% and Co was 49 atomic%.

### <Example 11>

An absorption layer made of platinum (Pt) and bismuth (Bi) was deposited on the capping layer.

A reflective photomask blank and a reflective photomask of Example 11 were prepared in the same manner as in Example 1 except for the absorption layer.

A composition of metal elements in the absorption layer of Example 11 thus formed was measured by Rutherford backscattering spectrometry (RBS), and it was found that Pt was 51 atomic% and Bi was 49 atomic%.

### <Example 12>

An absorption layer made of platinum (Pt) and gold (Au) was deposited on the capping layer.

A reflective photomask blank and a reflective photomask of Example 12 were prepared in the same manner as in Example 1 except for the absorption layer.

A composition of metal elements in the absorption layer of Example 12 thus formed was measured by Rutherford backscattering spectrometry (RBS), and it was found that Pt was 51 atomic% and Au was 49 atomic%.

### <Example 13>

An absorption layer made of platinum (Pt) and palladium (Pd) was deposited on the capping layer.

A reflective photomask blank and a reflective photomask of Example 13 were prepared in the same manner as in Example 1 except for the absorption layer.

A composition of metal elements in the absorption layer of Example 13 thus formed was measured by Rutherford backscattering spectrometry (RBS), and it was found that Pt was 51 atomic% and Pd was 49 atomic%.

### <Example 14>

An absorption layer made of platinum (Pt) and rhenium (Re) was deposited on the capping layer.

A reflective photomask blank and a reflective photomask of Example 14 were prepared in the same manner as in Example 1 except for the absorption layer.

A composition of metal elements in the absorption layer of Example 14 thus formed was measured by Rutherford backscattering spectrometry (RBS), and it was found that Pt was 51 atomic% and Re was 49 atomic%.

### <Example 15>

An absorption layer made of platinum (Pt) and indium nitride (In₃N₂) was deposited on the capping layer.

A reflective photomask blank and a reflective photomask of Example 15 were prepared in the same manner as in Example 1 except for the absorption layer.

A composition of metal elements in the absorption layer of Example 15 thus formed was measured by Rutherford backscattering spectrometry (RBS), and it was found that Pt was 51 atomic% and In₃N₂ (total of In and N) was 49 atomic%.

### <Example 16>

An absorption layer made of platinum (Pt) and indium nitride (In₇N₃) was deposited on the capping layer.

A reflective photomask blank and a reflective photomask of Example 16 were prepared in the same manner as in Example 1 except for the absorption layer.

A composition of metal elements in the absorption layer of Example 16 thus formed was measured by Rutherford backscattering spectrometry (RBS), and it was found that Pt was 60 atomic% and In₇N₃ (total of In and N) was 40 atomic%.

### <Example 17>

An absorption layer made of platinum (Pt) and indium nitride (In₆N₅) was deposited on the capping layer.

A reflective photomask blank and a reflective photomask of Example 17 were prepared in the same manner as in Example 1 except for the absorption layer.

A composition of metal elements in the absorption layer of Example 17 thus formed was measured by Rutherford backscattering spectrometry (RBS), and it was found that Pt was 60 atomic% and In₆N₅ (total of In and N) was 40 atomic%.

### <Example 18>

An absorption layer made of platinum (Pt) and indium nitride (InN) was deposited on the capping layer.

A reflective photomask blank and a reflective photomask of Example 18 were prepared in the same manner as in Example 1 except for the absorption layer.

A composition of metal elements in the absorption layer of Example 18 thus formed was measured by Rutherford backscattering spectrometry (RBS), and it was found that Pt was 75 atomic% and InN (total of In and N) was 25 atomic%.

### <Example 19>

An absorption layer made of platinum (Pt) and rhenium bismuth (BiRe) was deposited on the multilayer reflective film without providing the capping layer.

A reflective photomask blank and a reflective photomask of Example 19 were prepared in the same manner as in Example 1 except for the absorption layer.

A composition of metal elements in the absorption layer of Example 19 thus formed was measured by Rutherford backscattering spectrometry (RBS), and it was found that Pt was 40 atomic% and BiRe (total of Bi and Re) was 60 atomic%.

### <Example 20>

An absorption layer made of platinum (Pt) and hafnium lead (HfPb) was deposited on the multilayer reflective film without providing the capping layer.

A reflective photomask blank and a reflective photomask of Example 20 were prepared in the same manner as in Example 1 except for the absorption layer.

A composition of metal elements in the absorption layer of Example 20 thus formed was measured by Rutherford backscattering spectrometry (RBS), and it was found that Pt was 40 atomic% and HfPb (total of Hf and Pb) was 60 atomic%.

### <Example 21>

An absorption layer made of platinum (Pt) and hafnium lead (Hf₂Pb₃) was deposited on the multilayer reflective film without providing the capping layer.

A reflective photomask blank and a reflective photomask of Example 21 were prepared in the same manner as in Example 1 except for the absorption layer.

A composition of metal elements in the absorption layer of Example 21 thus formed was measured by Rutherford backscattering spectrometry (RBS), and it was found that Pt was 51 atomic% and Hf₂Pb₃ (total of Hf and Pb) was 49 atomic%.

### <Example 22>

An absorption layer made of platinum (Pt) and yttrium lead (Y₅Pb₇) was deposited on the multilayer reflective film without providing the capping layer.

A reflective photomask blank and a reflective photomask of Example 22 were prepared in the same manner as in Example 1 except for the absorption layer.

A composition of metal elements in the absorption layer of Example 22 thus formed was measured by Rutherford backscattering spectrometry (RBS), and it was found that Pt was 40 atomic% and Y₅Pb₇ (total of Y and Pb) was 60 atomic%.

### <Example 23>

An absorption layer made of platinum (Pt) and yttrium lead (Y₅Pb₇) was deposited on the capping layer.

A reflective photomask blank and a reflective photomask of Example 23 were prepared in the same manner as in Example 1 except for the absorption layer.

A composition of metal elements in the absorption layer of Example 23 thus formed was measured by Rutherford backscattering spectrometry (RBS), and it was found that Pt was 40 atomic% and Y₅Pb₇ (total of Y and Pb) was 60 atomic%.

### <Example 24>

An absorption layer made of platinum (Pt), ruthenium, and nitrogen (Ru + N) was deposited on the capping layer.

A reflective photomask blank and a reflective photomask of Example 24 were prepared in the same manner as in Example 1 except for the absorption layer.

A composition of metal elements in the absorption layer of Example 24 thus formed was measured by Rutherford backscattering spectrometry (RBS), and it was found that Pt was 51 atomic% and a total of Ru and N was 49 atomic%.

When measured by secondary ion mass spectrometry (SIMS), N was 0.001 atomic%.

### <Example 25>

An absorption layer made of platinum (Pt), ruthenium, and nitrogen (Ru + N) was deposited on the capping layer.

A reflective photomask blank and a reflective photomask of Example 25 were prepared in the same manner as in Example 1 except for the absorption layer.

A composition of metal elements in the absorption layer of Example 25 thus formed was measured by Rutherford backscattering spectrometry (RBS), and it was found that Pt was 51 atomic% and a total of Ru and N was 49 atomic%.

When measured by secondary ion mass spectrometry (SIMS), N was 1 atomic%.

### <Example 26>

An absorption layer made of platinum (Pt), ruthenium, and nitrogen (Ru + N) was deposited on the capping layer.

A reflective photomask blank and a reflective photomask of Example 26 were prepared in the same manner as in Example 1 except for the absorption layer.

A composition of metal elements in the absorption layer of Example 26 thus formed was measured by Rutherford backscattering spectrometry (RBS), and it was found that Pt was 51 atomic% and a total of Ru and N was 49 atomic%.

When measured by secondary ion mass spectrometry (SIMS), N was 0.1 atomic%.

### <Example 27>

An absorption layer made of platinum (Pt), ruthenium, and boron (Ru + B) was deposited on the capping layer.

A reflective photomask blank and a reflective photomask of Example 27 were prepared in the same manner as in Example 1 except for the absorption layer.

A composition of metal elements in the absorption layer of Example 27 thus formed was measured by Rutherford backscattering spectrometry (RBS), and it was found that Pt was 51 atomic% and a total of Ru and B was 49 atomic%.

When measured by secondary ion mass spectrometry (SIMS), B was 0.1 atomic%.

### <Example 28>

An absorption layer made of platinum (Pt), ruthenium, and oxygen (Ru + O) was deposited on the capping layer.

A reflective photomask blank and a reflective photomask of Example 28 were prepared in the same manner as in Example 1 except for the absorption layer.

A composition of metal elements in the absorption layer of Example 28 thus formed was measured by Rutherford backscattering spectrometry (RBS), and it was found that Pt was 51 atomic% and a total of Ru and O was 49 atomic%.

When measured by secondary ion mass spectrometry (SIMS), O was 0.1 atomic%.

### <Example 29>

An absorption layer made of platinum (Pt) and yttrium (Y) was deposited on the multilayer reflective film without providing the capping layer.

A reflective photomask blank and a reflective photomask of Example 29 were prepared in the same manner as in Example 1 except for the absorption layer.

A composition of metal elements in the absorption layer of Example 29 thus formed was measured by Rutherford backscattering spectrometry (RBS), and it was found that Pt was 51 atomic% and a total of Y was 49 atomic%.

### <Example 30>

An absorption layer made of platinum (Pt), yttrium, and carbon (Y + C) was deposited on the multilayer reflective film without providing the capping layer.

A reflective photomask blank and a reflective photomask of Example 30 were prepared in the same manner as in Example 1 except for the absorption layer.

A composition of metal elements in the absorption layer of Example 30 thus formed was measured by Rutherford backscattering spectrometry (RBS), and it was found that Pt was 51 atomic% and a total of Y and C was 49 atomic%.

When measured by secondary ion mass spectrometry (SIMS), C was 2 atomic%.

### <Example 31>

An absorption layer made of platinum (Pt), palladium, and carbon (Pd + C) was deposited on the capping layer.

A reflective photomask blank and a reflective photomask of Example 31 were prepared in the same manner as in Example 1 except for the absorption layer.

A composition of metal elements in the absorption layer of Example 31 thus formed was measured by Rutherford backscattering spectrometry (RBS), and it was found that Pt was 51 atomic% and a total of Pd and C was 49 atomic%.

When measured by secondary ion mass spectrometry (SIMS), C was 2 atomic%.

### <Example 32>

An absorption layer made of platinum (Pt) and ruthenium (Ru) was deposited on the capping layer.

A reflective photomask blank and a reflective photomask of Example 32 were prepared in the same manner as in Example 1 except for the absorption layer.

A composition of metal elements in the absorption layer of Example 32 thus formed was measured by Rutherford backscattering spectrometry (RBS), and it was found that Pt was 60 atomic% and Ru was 40 atomic%.

### <Example 33>

An absorption layer made of platinum (Pt) and ruthenium (Ru) was deposited on the capping layer.

A reflective photomask blank and a reflective photomask of Example 33 were prepared in the same manner as in Example 1 except for the absorption layer.

A composition of metal elements in the absorption layer of Example 33 thus formed was measured by Rutherford backscattering spectrometry (RBS), and it was found that Pt was 70 atomic% and Ru was 30 atomic%.

### <Example 34>

An absorption layer made of platinum (Pt) and ruthenium (Ru) was deposited on the capping layer.

A reflective photomask blank and a reflective photomask of Example 34 were prepared in the same manner as in Example 1 except for the absorption layer.

A composition of metal elements in the absorption layer of Example 34 thus formed was measured by Rutherford backscattering spectrometry (RBS), and it was found that Pt was 99 atomic% and Ru was 1 atomic%.

### <Comparative Example 1>

An absorption layer made of platinum (Pt) and titanium (Ti) was deposited on the capping layer.

A reflective photomask blank and a reflective photomask of Comparative Example 1 were prepared in the same manner as in Example 1 except for the absorption layer.

A composition of metal elements in the absorption layer of Comparative Example 1 thus formed was measured by Rutherford backscattering spectrometry (RBS), and it was found that Pt was 19 atomic% and Ti was 81 atomic%.

### <Comparative Example 2>

An absorption layer made of platinum (Pt) and titanium (Ti) was deposited on the capping layer.

A reflective photomask blank and a reflective photomask of Comparative Example 2 were prepared in the same manner as in Example 1 except for the absorption layer.

A composition of metal elements in the absorption layer of Comparative Example 2 thus formed was measured by Rutherford backscattering spectrometry (RBS), and it was found that Pt was 29 atomic% and Ti was 71 atomic%.

### <Comparative Example 3>

An absorption layer made of platinum (Pt) and bismuth (Bi) was deposited on the capping layer.

A reflective photomask blank and a reflective photomask of Comparative Example 3 were prepared in the same manner as in Example 1 except for the absorption layer.

A composition of metal elements in the absorption layer of Comparative Example 3 thus formed was measured by Rutherford backscattering spectrometry (RBS), and it was found that Pt was 70 atomic% and Bi was 30 atomic%.

Evaluation items for evaluating the reflective photomask blanks obtained in Examples 1 to 34 and Comparative Examples 1 to 3 are described below.

### (Film Density Evaluation)

A film density was evaluated based on a measurement result of Rutherford backscattering spectrometry (RBS) in the following four levels of "⊚", "○", "△", and "×".

### <Evaluation Criteria>

⊚: when the film density is 11.0 g/cm³ or more
○: when the film density is 10.0 g/cm³ or more and less than 11.0 g/cm³
△: when the film density is 9.0 g/cm³ or more and less than 10.0 g/cm³
×: when the film density is less than 9.0 g/cm³

### (Hydrogen Radical Resistance Evaluation)

A sample was subjected to hydrogen radical irradiation with power of 1 kW and hydrogen pressure of 0.36 millibar (mbar) or less using microwave plasma. Thereafter, an etching rate of the absorption layer due to immersion in a cleaning liquid was calculated based on a film thickness measurement using an atomic force microscope, and an evaluation was performed based on the following three levels of "⊚", "○", and "×". In the present evaluation, the etching rate was calculated on a plurality of samples for each of Examples and Comparative Examples.

### <Evaluation Criteria>

⊚: when a film loss rate is 0.1 nm/s or less in all measurement results
○: when the film loss rate is 0.1 nm/s or less in half or more of the measurement results
×: when the film loss rate is more than 0.1 nm/s in all the measurement results

With respect to hydrogen radical resistance, evaluations of "⊚" and "○" were "acceptable" since there was no problem in using the reflective photomask blank.

From the above results, it was clear that there was a certain relationship between the film loss rate of the absorption layer due to the hydrogen radical irradiation and the film density of the absorption layer. With respect to the relationship between the film loss rate of the absorption layer and the film density of the absorption layer, the film density of the absorption layer tended to be high when the film loss rate of the absorption layer due to hydrogen radical irradiation was low.

The above evaluation results are shown in Table 1. The "film thickness" shown in Table 1 was measured using a known film thickness meter. The "film thickness" shown in Table 1 means a total thickness of the absorption layer.

**[Table 1]**

| Example | Pt composition among metal atoms (at%) | Mixed material | Film density | | H* Resistance Evaluation ⊚○× | Film thickness | Presence of capping layer |
|---|---|---|---|---|---|---|---|
| | | Material name | (g/cm3) | Evaluation | | (nm) | |
| 1 | 51 | Ti | 10.00 | ○ | ⊚ | 45 | ○ |
| 2 | 60 | Ti | 14.08 | ⊚ | ⊚ | 45 | ○ |
| 3 | 70 | Ti | 15.84 | ⊚ | ⊚ | 45 | ○ |
| 4 | 99 | Ti | 21.25 | ⊚ | ⊚ | 45 | ○ |
| 5 | 51 | Ti2O | 9.00 | Δ | ○ | 55 | ○ |
| 6 | 51 | Nb | 14.57 | ⊚ | ⊚ | 59 | ○ |
| 7 | 51 | Cr | 15.27 | ⊚ | ⊚ | 59 | ○ |
| 8 | 51 | Ru | 17.24 | ⊚ | ⊚ | 59 | ○ |
| 9 | 51 | Ni | 16.30 | ⊚ | ⊚ | 59 | ○ |
| 10 | 51 | Co | 16.28 | ⊚ | ⊚ | 59 | ○ |
| 11 | 51 | Bi | 13.33 | ⊚ | ⊚ | 59 | ○ |
| 12 | 51 | Au | 20.35 | ⊚ | ⊚ | 59 | ○ |
| 13 | 51 | Pd | 9.45 | Δ | ⊚ | 59 | ○ |
| 14 | 51 | Re | 9.78 | Δ | ○ | 65 | ○ |
| 15 | 51 | In3N2 | 9.98 | Δ | ○ | 45 | ○ |
| 16 | 60 | In7N3 | 11.00 | ⊚ | ⊚ | 45 | ○ |
| 17 | 60 | In6N5 | 10.83 | ○ | ⊚ | 45 | ○ |
| 18 | 75 | InN | 13.18 | ⊚ | ⊚ | 45 | ○ |
| 19 | 40 | BiRe | 9.85 | Δ | ○ | 65 | × |
| 20 | 40 | HfPb | 9.28 | Δ | ⊚ | 65 | × |
| 21 | 51 | Hf2Pb3 | 9.76 | Δ | ⊚ | 65 | × |
| 22 | 40 | Y5Pb7 | 9.45 | Δ | ⊚ | 59 | × |
| 23 | 40 | Y5Pb7 | 9.45 | Δ | ⊚ | 65 | ○ |
| 24 | 51 | Ru+N | 17.72 | ⊚ | ⊚ | 59 | ○ |
| | | (N: 0.001 at% among all elements) | | | | | |
| 25 | 51 | Ru + N | 17.37 | ⊚ | ⊚ | 59 | ○ |
| | | (N: 1 at% among all elements) | | | | | |
| 26 | 51 | Ru + N | 17.54 | ⊚ | ⊚ | 45 | ○ |
| | | (N: 0.1 at% among all elements) | | | | | |
| 27 | 51 | Ru + B | 17.54 | ⊚ | ⊚ | 30 | ○ |
| | | (B: 0.1 at% among all elements) | | | | | |
| 28 | 51 | Ru + O | 17.54 | ⊚ | ⊚ | 59 | ○ |
| | | (O: 0.1 at% among all elements) | | | | | |
| 29 | 51 | Y | 9.95 | Δ | ⊚ | 65 | × |
| 30 | 51 | Y+C | 10.00 | ○ | ⊚ | 65 | × |
| | | (C: 2 at% among all elements) | | | | | |
| 31 | 51 | Pd+C | 9.50 | Δ | ⊚ | 59 | ○ |
| | | (C: 2 at% among all elements) | | | | | |
| 32 | 60 | Ru | 18.05 | ⊚ | ⊚ | 59 | ○ |
| 33 | 70 | Ru | 18.93 | ⊚ | ⊚ | 59 | ○ |
| 34 | 99 | Ru | 21.37 | ⊚ | ⊚ | 59 | ○ |

| Comparative Example | Pt composition among metal atoms (at%) | Mixed material | Film density | | H* Resistance Evaluation ABC | Film thickness | Presence of capping layer |
|---|---|---|---|---|---|---|---|
| | | Material name | (g/cm3) | Evaluation | | (nm) | |
| 1 | 19 | Ti | 8.00 | × | × | 45 | ○ |
| 2 | 29 | Ti | 8.95 | × | × | 65 | ○ |
| 3 | 70 | Bi | 7.00 | × | × | 45 | ○ |

In this way, it is possible to provide a reflective photomask blank and a reflective photomask for patterning transfer using light having a wavelength in an extreme ultraviolet region as a light source and in which the absorption film has hydrogen radical resistance, when the reflective photomask blank includes the substrate 1, the reflective layer 2 formed on the substrate 1 to reflect EUV light, and the absorption layer 4 formed on the reflective layer 2 to absorb EUV light, in which the absorption layer 4 contains platinum (Pt) in a largest amount among all elements constituting the absorption layer 4 and contains at least one element selected from the first material group other than platinum (Pt), the absorption layer 4 has a film density of 9.0 g/cm³ or more, and the reflective photomask is formed using the reflective photomask blank.

For example, the present invention may have the following configurations.
(1) A reflective mask blank including:
   a substrate;
   a reflective layer formed on the substrate and configured to reflect EUV light; and
   an absorption layer formed on the reflective layer and configured to absorb EUV light, in which
   the absorption layer contains platinum (Pt) in a largest amount among all elements constituting the absorption layer and contains at least one element selected from a first material group other than the platinum (Pt), and
   the absorption layer has a film density of 9.0 g/cm³ or more.
(2) The reflective mask blank according to (1), in which the first material group comprises niobium (Nb), ruthenium (Ru), iridium (Ir), tantalum (Ta), titanium (Ti), chromium (Cr), indium (In), nickel (Ni), cobalt (Co), bismuth (Bi), iron (Fe), gold (Au), palladium (Pd), rhenium (Re), tin (Sn), oxygen (O), nitrogen (N), and boron (B).
(3) The reflective mask blank according to (1), in which the first material group comprises niobium (Nb), ruthenium (Ru), iridium (Ir), tantalum (Ta), titanium (Ti), chromium (Cr), indium (In), oxygen (O), nitrogen (N), and boron (B).
(4) The reflective mask blank according to any one of (1) to (3), in which the absorption layer contains 51 atomic% or more of platinum (Pt) among metal elements contained in the absorption layer.
(5) The reflective mask blank according to any one of (1) to (3), in which the absorption layer contains 60 atomic% or more of platinum (Pt) among metal elements contained in the absorption layer.
(6) The reflective mask blank according to any one of (1) to (3), in which the absorption layer contains 70 atomic% or more of platinum (Pt) among metal elements contained in the absorption layer.
(7) The reflective mask blank according to any one of (1) to (6), in which the absorption layer has a film density of 9.5 g/cm³ or more.
(8) The reflective mask blank according to any one of (1) to (6), in which the absorption layer has a film density of 10.0 g/cm³ or more.
(9) The reflective mask blank according to any one of (1) to (8), in which the absorption film has a film thickness of less than 60 nm.
(10) The reflective mask blank according to any one of (1) to (8), in which the absorption film has a film thickness of 55 nm or less.
(11) The reflective mask blank according to any one of (1) to (8), in which the absorption film has a film thickness of 45 nm or less.
(12) The reflective mask blank according to any one of (1) to (11), further including: a capping layer between the reflective layer and the absorption layer.
(13) A reflective mask including:
   a substrate;
   a reflective layer formed on the substrate and configured to reflect EUV light; and
   a patterned absorption layer formed on the reflective layer and configured to absorb EUV light, in which
   the absorption layer contains platinum (Pt) in a largest amount among elements constituting the absorption layer and contains at least one element selected from a first material group other than the platinum (Pt), and
   the absorption layer has a film density of 9.0 g/cm³ or more.
(14) The reflective mask according to (13), in which the first material group comprises niobium (Nb), ruthenium (Ru), iridium (Ir), tantalum (Ta), titanium (Ti), chromium (Cr), indium (In), nickel (Ni), cobalt (Co), bismuth (Bi), iron (Fe), gold (Au), palladium (Pd), rhenium (Re), tin (Sn), oxygen (O), nitrogen (N), and boron (B).
(15) The reflective mask according to (13), in which the first material group comprises niobium (Nb), ruthenium (Ru), iridium (Ir), tantalum (Ta), titanium (Ti), chromium (Cr), indium (In), oxygen (O), nitrogen (N), and boron (B).
(16) The reflective mask according to any one of (13) to (15), in which the absorption layer contains 51 atomic% or more of platinum (Pt) among metal elements contained in the absorption layer.
(17) The reflective mask according to any one of (13) to (15), in which the absorption layer contains 60 atomic% or more of platinum (Pt) among metal elements contained in the absorption layer.
(18) The reflective mask according to any one of (13) to (15), in which the absorption layer contains 70 atomic% or more of platinum (Pt) among metal elements contained in the absorption layer.
(19) The reflective mask according to any one of (13) to (18), in which the absorption layer has a film density of 9.5 g/cm³ or more.
(20) The reflective mask according to any one of (13) to (18), in which the absorption layer has a film density of 10.0 g/cm³ or more.
(21) The reflective mask according to any one of (13) to (20), in which the absorption film has a film thickness of less than 60 nm.
(22) The reflective mask according to any one of (13) to (20), in which the absorption film has a film thickness of 55 nm or less.
(23) The reflective mask according to any one of (13) to (20), in which the absorption film has a film thickness of 45 nm or less.
(24) The reflective mask according to any one of (13) to (23), further including: a capping layer between the reflective layer and the absorption layer.
(25) A method for producing a reflective mask including:
   forming, on a substrate, a reflective layer that reflects EUV light; and
   forming, on the reflective layer, an absorption layer that absorbs EUV light and is patterned, in which
   the absorption layer contains platinum (Pt) in a largest amount among elements constituting the absorption layer and contains at least one element selected from a first material group other than the platinum (Pt), and
   the absorption layer has a film density of 9.0 g/cm³ or more.
(26) The method for producing a reflective mask according to (25), in which the first material group comprises niobium (Nb), ruthenium (Ru), iridium (Ir), tantalum (Ta), titanium (Ti), chromium (Cr), indium (In), nickel (Ni), cobalt (Co), bismuth (Bi), iron (Fe), gold (Au), palladium (Pd), rhenium (Re), tin (Sn), oxygen (O), nitrogen (N), and boron (B).
(27) The method for producing a reflective mask according to (25), in which the first material group comprises niobium (Nb), ruthenium (Ru), iridium (Ir), tantalum (Ta), titanium (Ti), chromium (Cr), indium (In), oxygen (O), nitrogen (N), and boron (B).
(28) The method for producing a reflective mask according to any one of (25) to (27), in which the absorption layer contains 51 atomic% or more of platinum (Pt) among metal elements contained in the absorption layer.
(29) The method for producing a reflective mask according to any one of (25) to (27), in which the absorption layer contains 60 atomic% or more of platinum (Pt) among metal elements contained in the absorption layer.
(30) The method for producing a reflective mask according to any one of (25) to (27), in which the absorption layer contains 70 atomic% or more of platinum (Pt) among metal elements contained in the absorption layer.
(31) The method for producing a reflective mask according to any one of (25) to (30), in which the absorption layer has a film density of 9.5 g/cm³ or more.
(32) The method for producing a reflective mask according to any one of (25) to (30), in which the absorption layer has a film density of 10.0 g/cm³ or more.
(33) The method for producing a reflective mask according to any one of (25) to (32), in which the absorption film has a film thickness of less than 60 nm.
(34) The method for producing a reflective mask according to any one of (25) to (32), in which the absorption film has a film thickness of 55 nm or less.
(35) The method for producing a reflective mask according to any one of (25) to (32), in which the absorption film has a film thickness of 45 nm or less.
(36) The method for producing a reflective mask according to any one of (25) to (35), further including: a capping layer between the reflective layer and the absorption layer.

### INDUSTRIAL APPLICABILITY

A reflective photomask according to the present invention can be suitably used for forming a fine pattern by EUV exposure in a production step of a semiconductor integrated circuit or the like.

### REFERENCE SIGNS LIST

1... substrate
2... reflective layer
3... protective layer (capping layer)
4... absorption layer
5... reflective portion
10... reflective photomask blank (reflective mask blank)
20... reflective photomask (reflective mask)

## Claims

1. A reflective mask blank comprising:
a substrate;
a reflective layer formed on the substrate and configured to reflect EUV light; and
an absorption layer formed on the reflective layer and configured to absorb EUV light, wherein
the absorption layer contains platinum (Pt) in a largest amount among all elements constituting the absorption layer and contains at least one element selected from a first material group other than the platinum (Pt), and
the absorption layer has a film density of 9.0 g/cm³ or more.

2. The reflective mask blank according to claim 1, wherein
the first material group comprises niobium (Nb), ruthenium (Ru), iridium (Ir), tantalum (Ta), titanium (Ti), chromium (Cr), indium (In), nickel (Ni), cobalt (Co), bismuth (Bi), iron (Fe), gold (Au), palladium (Pd), rhenium (Re), tin (Sn), oxygen (O), nitrogen (N), and boron (B).

3. The reflective mask blank according to claim 1, wherein
the first material group comprises niobium (Nb), ruthenium (Ru), iridium (Ir), tantalum (Ta), titanium (Ti), chromium (Cr), indium (In), oxygen (O), nitrogen (N), and boron (B).

4. The reflective mask blank according to claim 3, wherein
the absorption layer contains 51 atomic% or more of platinum (Pt) among metal elements contained in the absorption layer.

5. The reflective mask blank according to claim 3, wherein
the absorption layer contains 60 atomic% or more of platinum (Pt) among metal elements contained in the absorption layer.

6. The reflective mask blank according to claim 3, wherein
the absorption layer contains 70 atomic% or more of platinum (Pt) among metal elements contained in the absorption layer.

7. The reflective mask blank according to claim 6, wherein
the absorption layer has a film density of 9.5 g/cm³ or more.

8. The reflective mask blank according to claim 6, wherein
the absorption layer has a film density of 10.0 g/cm³ or more.

9. The reflective mask blank according to claim 8, wherein
the absorption film has a film thickness of less than 60 nm.

10. The reflective mask blank according to claim 8, wherein
the absorption film has a film thickness of 55 nm or less.

11. The reflective mask blank according to claim 8, wherein
the absorption film has a film thickness of 45 nm or less.

12. The reflective mask blank according to any one of claims 1 to 11, further comprising:
a capping layer between the reflective layer and the absorption layer.

13. A reflective mask comprising:
a substrate;
a reflective layer formed on the substrate and configured to reflect EUV light; and
a patterned absorption layer formed on the reflective layer and configured to absorb EUV light, wherein
the absorption layer contains platinum (Pt) in a largest amount among elements constituting the absorption layer and contains at least one element selected from a first material group other than the platinum (Pt), and
the absorption layer has a film density of 9.0 g/cm³ or more.

14. The reflective mask according to claim 13, wherein
the first material group comprises niobium (Nb), ruthenium (Ru), iridium (Ir), tantalum (Ta), titanium (Ti), chromium (Cr), indium (In), nickel (Ni), cobalt (Co), bismuth (Bi), iron (Fe), gold (Au), palladium (Pd), rhenium (Re), tin (Sn), oxygen (O), nitrogen (N), and boron (B).

15. The reflective mask according to claim 13, wherein
the first material group comprises niobium (Nb), ruthenium (Ru), iridium (Ir), tantalum (Ta), titanium (Ti), chromium (Cr), indium (In), oxygen (O), nitrogen (N), and boron (B).

16. The reflective mask according to claim 15, wherein
the absorption layer contains 51 atomic% or more of platinum (Pt) among metal elements contained in the absorption layer.

17. The reflective mask according to claim 15, wherein
the absorption layer contains 60 atomic% or more of platinum (Pt) among metal elements contained in the absorption layer.

18. The reflective mask according to claim 15, wherein
the absorption layer contains 70 atomic% or more of platinum (Pt) among metal elements contained in the absorption layer.

19. The reflective mask according to claim 18, wherein
the absorption layer has a film density of 9.5 g/cm³ or more.

20. The reflective mask according to claim 18, wherein
the absorption layer has a film density of 10.0 g/cm³ or more.

21. The reflective mask according to claim 20, wherein
the absorption film has a film thickness of less than 60 nm.

22. The reflective mask according to claim 20, wherein
the absorption film has a film thickness of 55 nm or less.

23. The reflective mask according to claim 20, wherein
the absorption film has a film thickness of 45 nm or less.

24. The reflective mask according to any one of claims 13 to 23, further comprising:
a capping layer between the reflective layer and the absorption layer.

25. A method for producing a reflective mask comprising:
forming, on a substrate, a reflective layer configured to reflect EUV light; and
forming, on the reflective layer, an absorption layer patterned and configured to absorb EUV light, wherein
the absorption layer contains platinum (Pt) in a largest amount among elements constituting the absorption layer and contains at least one element selected from a first material group other than the platinum (Pt), and
the absorption layer has a film density of 9.0 g/cm³ or more.

26. The method for producing a reflective mask according to claim 25, wherein
the first material group comprises niobium (Nb), ruthenium (Ru), iridium (Ir), tantalum (Ta), titanium (Ti), chromium (Cr), indium (In), nickel (Ni), cobalt (Co), bismuth (Bi), iron (Fe), gold (Au), palladium (Pd), rhenium (Re), tin (Sn), oxygen (O), nitrogen (N), and boron (B).

27. The method for producing a reflective mask according to claim 25, wherein
the first material group comprises niobium (Nb), ruthenium (Ru), iridium (Ir), tantalum (Ta), titanium (Ti), chromium (Cr), indium (In), oxygen (O), nitrogen (N), and boron (B).

28. The method for producing a reflective mask according to claim 27, wherein
the absorption layer contains 51 atomic% or more of platinum (Pt) among metal elements contained in the absorption layer.

29. The method for producing a reflective mask according to claim 27, wherein
the absorption layer contains 60 atomic% or more of platinum (Pt) among metal elements contained in the absorption layer.

30. The method for producing a reflective mask according to claim 27, wherein
the absorption layer contains 70 atomic% or more of platinum (Pt) among metal elements contained in the absorption layer.

31. The method for producing a reflective mask according to claim 30, wherein
the absorption layer has a film density of 9.5 g/cm³ or more.

32. The method for producing a reflective mask according to claim 30, wherein
the absorption layer has a film density of 10.0 g/cm³ or more.

33. The method for producing a reflective mask according to claim 32, wherein
the absorption film has a film thickness of less than 60 nm.

34. The method for producing a reflective mask according to claim 32, wherein
the absorption film has a film thickness of 55 nm or less.

35. The method for producing a reflective mask according to claim 32, wherein
the absorption film has a film thickness of 45 nm or less.

36. The method for producing a reflective mask according to any one of claims 25 to 35, further comprising:
a capping layer between the reflective layer and the absorption layer.
